(19) Europäisches Patentamt / European Patent Office / Office européen des brevets

(11) **EP 3 014 292 B1**

(12) **FASCICULE DE BREVET EUROPEEN**

(45) Date de publication et mention
de la délivrance du brevet:
**03.05.2017 Bulletin 2017/18**

(21) Numéro de dépôt: **14738430.9**

(22) Date de dépôt: **24.06.2014**

(51) Int Cl.:
*G01R 31/36* (2006.01)　　*H01M 10/48* (2006.01)

(86) Numéro de dépôt international:
**PCT/EP2014/063297**

(87) Numéro de publication internationale:
**WO 2014/206989 (31.12.2014 Gazette 2014/53)**

(54) **PROCEDE D'EVALUATION DE L'ETAT DE CHARGE D'UNE BATTERIE**

VERFAHREN ZUR BERECHNUNG DES LADEZUSTANDES EINER BATTERIE

METHOD FOR EVALUATING THE STATE OF CHARGE OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.06.2013 FR 1356034**

(43) Date de publication de la demande:
**04.05.2016 Bulletin 2016/18**

(73) Titulaire: **Commissariat à l'Énergie Atomique et aux Énergies Alternatives
75015 Paris (FR)**

(72) Inventeur: **DELAPLAGNE, Tony
F-73190 CHALLES LES EAUX (FR)**

(74) Mandataire: **Novaimo
ActiTech 8
60 avenue Marie Curie
Archamps Technopole
74166 Saint Julien en Genevois Cedex (FR)**

(56) Documents cités:
**US-A- 5 061 898　　US-A1- 2005 225 301**

**Description**

L'invention concerne un procédé de gestion d'une batterie, comprenant plus particulièrement un procédé d'évaluation de l'état de charge et/ou de l'état de santé de la batterie, à partir de la détection d'une valeur prédéfinie d'un état de charge d'une batterie, pour notamment maîtriser l'évolution de son état avec le temps, avec son vieillissement. Elle concerne aussi une batterie en tant que telle comprenant un agencement permettant de mettre en oeuvre ce procédé. Enfin, elle concerne aussi un système de gestion de batterie mettant en oeuvre ce procédé de gestion de batterie.

La connaissance de l'état d'une batterie (ou accumulateur électrochimique) comprend notamment le calcul de son état de charge à tout moment de son existence, aussi appelé SOC pour sa dénomination anglo-saxonne de « State Of Charge ». Pour cela, une jauge (ou indicateur) d'état de charge est généralement associée à une telle batterie. Cette jauge est gérée par un système de gestion de la batterie, qui met en oeuvre l'estimation de l'état de charge de la batterie à partir d'algorithmes prédéfinis et de mesures réalisées par des capteurs associés à la batterie. Avec toutes les solutions de l'état de la technique, on note une dégradation de cette estimation de l'état de charge d'une batterie avec le temps, et avec son vieillissement. Pour pallier à ce phénomène, il est connu de mettre en oeuvre des phases dites de « recalage de la jauge d'état de charge », qui consistent en des adaptations avec le temps des algorithmes prédéfinis, par exemple des paramètres de ces algorithmes, pour leur permettre finalement d'atteindre une estimation fiable de manière durable.

Une première méthode de l'état de la technique pour mettre en oeuvre une phase de recalage de la jauge d'état de charge d'une batterie consiste à réaliser une pleine charge de la batterie, et éventuellement un équilibrage de cette batterie lorsqu'elle se compose de plusieurs cellules assemblées suivant une configuration série et / ou parallèle comme c'est par exemple le cas dans une architecture souvent dénommée « pack batterie ». Lorsque la pleine charge est atteinte, la jauge est recalée par son réglage à 100%.

Une seconde méthode alternative de l'état de la technique pour mettre en oeuvre une phase de recalage de la jauge d'état de charge d'une batterie consiste à réaliser une pleine décharge de la batterie, qui permet d'atteindre un état de charge nul qui permet de recaler la jauge à 0%.

Ainsi, ces phases de recalage consistent finalement en un positionnement des batteries dans une configuration totalement chargée ou déchargée, pour laquelle leur état de charge réel est connu, pour recaler les algorithmes d'estimation sur cette valeur réelle. Naturellement, un inconvénient de ces solutions de l'état de la technique est qu'elles nécessitent la mise en oeuvre régulière d'une charge ou décharge complète de la batterie, ce qui engendre une perte de temps.

Une autre méthode de recalage de la jauge d'état de charge d'une batterie consiste à mesurer la tension durant une phase de repos (sans courant de charge ou de décharge). Cette mesure peut être directement liée à un état de charge. Cependant cette méthode nécessite d'avoir un capteur de tension très précis car suivant les technologies de batteries utilisées, la mesure de tension à vide évolue très finement en fonction de son état de charge.

D'autre part, la gestion des batteries de l'état de la technique fait souvent appel à un indicateur complémentaire représentatif du vieillissement d'une batterie, souvent appelé par sa dénomination anglo-saxonne de « State Of Health » pour état de santé, ou plus simplement SOH. De manière similaire au phénomène explicité en référence avec l'estimation de l'état de charge, une estimation du SOH nécessite des phases de recalage pour pallier à la dérive des méthodes d'estimation. Un tel recalage repose en général sur une phase de décharge complète de la batterie suivie d'une charge complète, pour obtenir le total de la charge (en ampères-heure) Ah(tr) transmise à la batterie à l'instant tr de recalage pour qu'elle atteigne son état totalement chargé et équilibré. Cette mesure permet alors de calculer l'état de santé SOH(tr) de la batterie à l'instant tr par le calcul suivant :

$$ SOH(tr) = Ah(tr) / Ah(ti) $$

où Ah(ti) est le total de la charge (en ampères-heure) reçue par la même batterie dans son état neuf dans les mêmes conditions de charge.

Cette méthode présente donc les mêmes contraintes que pour l'estimation, celles induites par le recalage de la jauge d'état de charge, puisqu'elle nécessite une décharge et une recharge complètes de la batterie.

D'autres méthodes pertinentes sont divulguées dans US 5061898 A et dans US 2005/225301 A1.

Ainsi, un objet général de l'invention est de proposer une solution d'estimation de l'état de charge et/ou de l'état de santé d'une batterie qui ne comprend pas les inconvénients de l'état de la technique.

Plus particulièrement, un objet de l'invention est de proposer une solution d'estimation de l'état de charge et/ou de l'état de santé d'une batterie qui permet d'améliorer la précision de l'estimation tout en allégeant le procédé d'estimation.

L'invention porte sur un procédé d'évaluation de l'état de charge d'une batterie selon la revendication 1.

La recherche d'un point particulier de la courbe de dérivée temporelle de la tension aux bornes de la batterie peut consister en la détection d'une valeur maximale ou minimale sur une portion de cette courbe.

Lors de la mise en oeuvre du procédé de détection d'une valeur prédéfinie d'un état de charge, l'étape d'évaluation de la dérivée temporelle de la tension peut comprendre une étape d'estimation instantanée de la dérivée temporelle de la tension puis une étape de lissage des estimations de la dérivée.

L'étape de lissage peut comprendre une étape de calcul d'une moyenne sur une fourchette glissante des estimations de la dérivée.

Le procédé d'évaluation de l'état de charge d'une batterie peut comprendre une étape de détection pour détecter si l'état de charge de la batterie se trouve dans une plage permettant le lancement ou non d'une phase de recalage.

Le procédé d'évaluation de l'état de charge d'une batterie peut comprendre la mise en oeuvre d'une phase de recalage d'un algorithme d'estimation de l'état de santé de la batterie si la batterie est complètement déchargée.

La phase de recalage de l'algorithme d'estimation de l'état de santé de la batterie peut comprendre les étapes suivantes :

- charge de la batterie,
- estimation de la charge transmise à la batterie depuis le début de la charge,
- observation de la dérivée temporelle de la tension aux bornes de la batterie pour déterminer au moins un point particulier de cette dérivée,
- recalage de l'algorithme d'estimation de l'état de santé à partir de la charge totale transmise à la batterie jusqu'à l'atteinte dudit point particulier.

Le procédé d'évaluation de l'état de charge d'une batterie peut comprendre une étape de mesure de température de la batterie, et une étape de refroidissement ou réchauffement de la batterie si la température de la batterie ne se trouve pas dans une plage de plus ou moins 20% autour d'une valeur de température de référence.

Le procédé d'évaluation de l'état de charge d'une batterie peut comprendre une étape d'estimation de la dispersion des états de charge de plusieurs sous-ensembles de la batterie, et une étape d'équilibrage de ces états de charge si la dispersion se trouve au-delà d'un seuil, l'étape d'équilibrage étant réalisée préalablement à la mise en oeuvre du procédé de détection d'une valeur prédéfinie telle que défini précédemment.

Le procédé d'évaluation de l'état de charge d'une batterie peut comprendre l'évaluation de l'état de charge d'une batterie comprenant une ou plusieurs batterie(s) élémentaire(s) de type Lithium Manganèse Titanate, dont le lancement de la phase de recalage par charge de la batterie est accepté si l'état de charge est inférieur à 40% ou si l'état de charge est entre 56 et 60 %, et l'étape de recalage de la phase de recalage peut associer une valeur d'état de charge comprise entre 50 et 60%, voire entre 53 et 56%, pour un point maximum $P_{max}$ de la courbe de la dérivée temporelle de la tension aux bornes de la batterie, dont la valeur de la dérivée temporelle est comprise entre 10 et 13 V.s⁻¹, voire entre 11 et 12 V.s⁻¹, et/ou une valeur d'état de charge comprise entre 60 et 65% pour un point minimum $P_{min}$ de cette courbe, dont la valeur de la dérivée temporelle est comprise entre 4 et 5 V.s⁻¹, à une température entre 15 et 30 °C de la batterie.

Le procédé d'évaluation de l'état de charge d'une batterie peut comprendre l'évaluation de l'état de charge d'une batterie comprenant une ou plusieurs batterie(s) élémentaire(s) de type Lithium Manganèse Titanate, dont le lancement de la phase de recalage par décharge de la batterie est accepté si son état de charge est supérieur à 40% ou 50%, et l'étape de recalage de la phase de recalage peut associer une valeur d'état de charge comprise entre 32 et 35%, voire entre 30 et 36%, pour un point maximum $P_{max}$ de la courbe de la dérivée temporelle de la tension aux bornes de la batterie, dont la valeur de la dérivée temporelle est comprise entre -5,5 et -4,5 V.s⁻¹, et/ou une valeur d'état de charge comprise entre 40 et 46% pour un point minimum $P_{min}$ de cette courbe, dont la valeur de la dérivée temporelle est comprise entre -10 et -8 V.s⁻¹, à une température entre 15 et 30 °C de la batterie.

Le procédé d'évaluation de l'état de charge d'une batterie peut comprendre une étape préalable de calibration, consistant en une étape de tracé d'au moins une partie de la courbe de la dérivée temporelle de la tension aux bornes de la batterie en phase de charge ou décharge, la détection d'au moins un point particulier de cette courbe, et la mesure de l'état de charge associé audit au moins un point particulier.

Le procédé d'évaluation de l'état de charge d'une batterie peut mettre en oeuvre une évaluation de l'état de charge pour plusieurs batteries élémentaires d'un même pack batterie.

L'invention porte aussi sur un système comprenant une batterie et un calculateur associé à la batterie, le calculateur pilotant le procédé d'évaluation de son état de charge tel qu'explicité précédemment.

Le système peut comprendre au moins un capteur de température de la batterie et au moins un capteur de tension et/ou de courant aux bornes de la batterie, et un dispositif de communication de ces capteurs vers le calculateur pour lui transmettre leurs mesures.

La batterie peut être de type Lithium Manganèse Titanate.

Le système de gestion d'une batterie peut comprendre au moins un calculateur qui met en oeuvre et pilote le procédé d'évaluation de l'état de charge de la batterie tel qu'explicité précédemment.

L'invention porte aussi sur un support informatique lisible par une unité de gestion, caractérisé en ce qu'il comprend un programme informatique enregistré comprenant des moyens de codes de programme informatique de mise en oeuvre et pilotage du procédé d'évaluation de l'état de charge de la batterie tel qu'explicité précédemment.

Ces objets, caractéristiques et avantages de la présente invention seront exposés en détail dans la description suivante d'un mode de réalisation particulier fait à titre non-limitatif en relation avec les figures jointes parmi lesquelles :

La figure 1 représente un synoptique d'une phase de recalage d'un procédé d'estimation de l'état de charge et/ou de l'état de santé d'une batterie selon un mode de réalisation de l'invention.

Les figures 2 à 5 représentent l'évolution de la dérivée temporelle de la tension aux bornes d'une batterie en fonction de son état de charge lors d'une phase de charge, respectivement pour différents états de vieillissement de la batterie à titre d'exemples.

Les figures 6 à 8 représentent l'évolution de la dérivée temporelle de la tension aux bornes d'une batterie en fonction de son état de charge lors d'une phase de décharge, respectivement pour différents états de vieillissement de la batterie à titre d'exemples.

Le procédé d'estimation de l'état de charge d'une batterie selon un mode de réalisation avantageux de l'invention comprend des phases d'estimation, durant lesquelles une méthode d'estimation est mise en oeuvre, interrompues par des étapes de recalage. Ces étapes de recalage permettent, à partir d'une valeur précise d'état de charge, de recaler les calculs mis en oeuvre durant les phases d'estimation, pour modifier par exemple les paramètres des calculs mis en oeuvre par les algorithmes utilisés lors des phases d'estimation et actualiser les valeurs des paramètres pour tenir compte du vieillissement de la batterie, mais également d'une éventuelle dérives des mesures effectuées par les capteurs, notamment la température. Cette actualisation, ou encore compensation, est réalisée selon la même approche que celle explicitée en rapport avec l'état de la technique.

Toutefois, les phases de recalage, qui seront détaillées par la suite, permettent d'obtenir au moins une valeur précise et fiable de l'état de charge d'une batterie, de manière plus simple et moins contraignante qu'avec les solutions de l'état de la technique, quel que soit le vieillissement de la batterie. Cette approche permet ainsi de mettre en oeuvre les phases de recalage selon une occurrence plus importante qu'avec les méthodes de l'état de la technique, ce qui permet d'améliorer globalement la précision de l'estimation de l'état de charge d'une batterie. Cette occurrence sera choisie pour atteindre un compromis optimal entre une grande précision de l'estimation de l'état de charge et la simplicité du procédé global d'estimation de l'état de charge. Il est aussi possible de choisir un algorithme d'estimation de l'état de charge plus simple et moins robuste, dont la baisse de performance sera au moins compensée par des phases de recalage plus nombreuses.

Une phase de recalage de l'estimation de l'état de charge d'une batterie selon un mode de réalisation va maintenant être explicitée. Cette phase de recalage nécessite l'observation de l'évolution de la dérivée temporelle de la tension aux bornes de la batterie lors de sa charge.

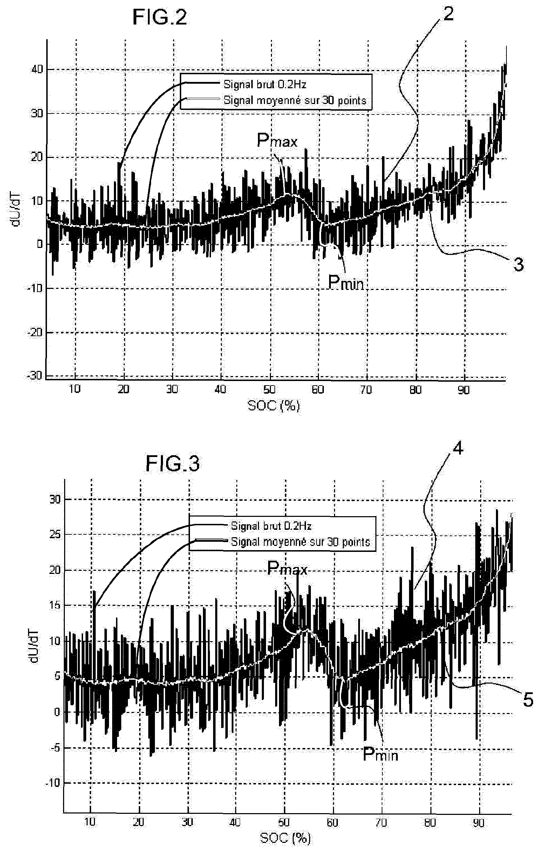

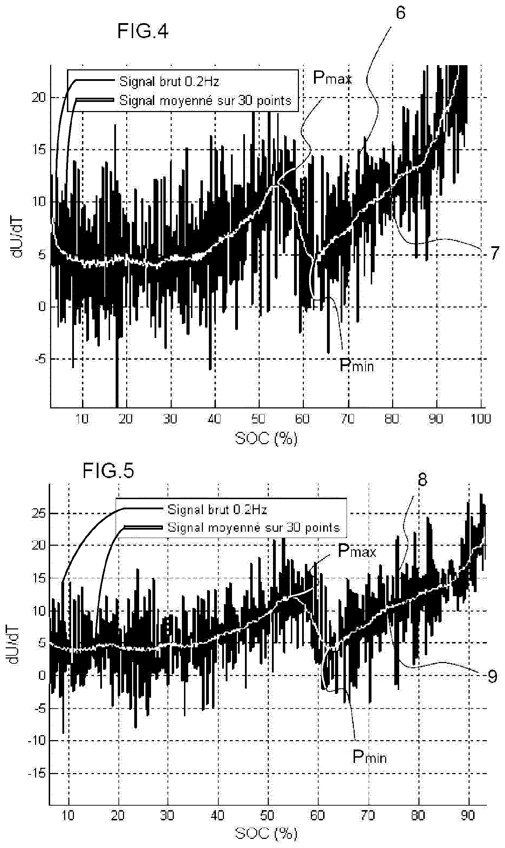

Les figures 2 à 5 représentent à titre d'exemple respectivement des courbes 3, 5, 7, 9 montrant l'évolution de la dérivée temporelle de la tension aux bornes d'un pack batterie de technologie Lithium Manganèse Titanate en fonction de l'état de charge de ce pack batterie pour respectivement différents états de vieillissements de la batterie, plus précisément pour respectivement 3400, 5800, 8250, et 16900 cycles de charges/décharges de la batterie. Ces courbes sont établies lors d'une phase de charge de la batterie. Les micro-cycles correspondent à des charges et décharges partielles réalisées sur 25% de profondeur de décharge, c'est-à-dire entre 55% et 80% d'état de charge SOC. On peut noter que la batterie a perdu 6% de capacité après 16900 micro-cycles.

L'obtention de ces courbes 3, 5, 7, 9 peut être obtenue par les étapes suivantes :

- A partir de l'état totalement déchargé de la batterie, charge de la batterie dans des conditions nominales ;
- Mesure de la tension aux bornes de la batterie au cours de cette charge, à l'aide d'un capteur de mesure, selon une fréquence de 0,2 Hz ;
- Calcul de la dérivée temporelle de la tension, ce qui donne les courbes 2, 4, 6, 8 sur respectivement les figures 2 à 5 ;
- Calcul de la moyenne glissante des valeurs de la dérivée temporelle de la tension obtenues précédemment, sur une fenêtre d'une durée 150 s (ce qui représente 30 valeurs pour la fréquence choisie) : cette moyenne glissante permet de tracer les courbes 3, 5, 7, 9 présentées ci-dessus et de s'affranchir des oscillations obtenues par les évaluations instantanées, visibles sur les courbes 2, 4, 6 et 8.

Naturellement, les paramètres mentionnés ci-dessus le sont à titre d'exemple, et il est possible d'obtenir de telles courbes dans d'autres conditions de charge électrique et/ou avec d'autres paramètres de mesures ou d'estimations de la tension de la batterie et de calcul de la dérivée temporelle de cette tension. Avantageusement, cette dérivée temporelle est filtrée, pour obtenir les courbes 3, 5, 7, et 9 lissées, par rapport aux courbes 2, 4, 6, et 8 issues des mesures brutes. L'opération de filtrage réalisée est du type « passe-bas », afin de moyenner les valeurs de dérivées calculées.

Les courbes 3, 5, 7 et 9 montrent que la dérivée temporelle de la tension présente une forme similaire quel que soit l'état de vieillissement de la batterie, et présentent notamment deux points particuliers qui sont d'une part un maximum $P_{max}$ et d'autre part un minimum $P_{min}$, obtenus respectivement pour des valeurs de l'état de charge de respectivement 54% et 62%, de manière sensiblement indépendante du vieillissement de la batterie, à une température de la batterie comprise entre 15 et 30 °C. Plus généralement, le point maximum $P_{max}$ de la courbe de la dérivée temporelle de la tension aux bornes de la batterie est obtenu pour une valeur d'état de charge comprise entre 50 et 60%, voire entre 53 et 56%. De plus, on note que la dérivée temporelle de la tension prend une valeur de 11,5 V.s$^{-1}$, à ce point maximum $P_{max}$, plus généralement entre 10 et 13 V.s$^{-1}$, voire entre 11 et 12 V.s$^{-1}$. De plus, le point minimum $P_{min}$ de la courbe de la dérivée temporelle de la tension aux bornes de la batterie est obtenu pour une valeur d'état de charge comprise entre 60 et 65%, et la dérivée temporelle de la tension prend une valeur de 4,3 V.s$^{-1}$ à ce point minimum $P_{min}$, plus généralement entre 4 et 5 V.s$^{-1}$.

Cette constatation est vraie pour des architectures de batteries plus ou moins complexes, comprenant par exemple une multitude de batteries élémentaires associées en série et/ou parallèle, formant un pack batterie. Ainsi, pour une batterie donnée, l'observation d'au moins un de ces points particuliers de la courbe de dérivée temporelle de la tension de la batterie permet d'indiquer avec une précision satisfaisante une valeur de l'état de charge de la batterie, que nous considérons comme une valeur réelle de cet état de charge.

La précision est d'autant plus satisfaisante que les batteries élémentaires sont équilibrées et présentent des niveaux de charge proches. Autrement dit, plus la dispersion des niveaux de charge des batteries élémentaires est faible meilleure sera la précision.

Sur la base de cette constatation, le principe mis en oeuvre dans une phase de recalage d'un procédé d'estimation de l'état de charge d'une batterie consiste en une estimation de la courbe de dérivée temporelle de la tension aux bornes de la batterie lors de sa charge, et en une détermination d'au moins un point particulier de cette courbe, qui permet d'en déduire avec précision une valeur réelle de l'état de charge de la batterie, qui sert au recalage du modèle d'estimation de l'état de charge de la batterie, utilisé hors des phases de recalage.

La notion de valeur réelle de l'état de charge est définie par opposition à une valeur estimée de l'état de charge qui correspond à une valeur calculée au moyen d'un algorithme de calcul de l'état de charge. Les algorithmes de calcul, ou d'estimation, utilisent des valeurs de grandeurs physiques, par exemple la tension aux bornes de la batterie, pour calculer une valeur estimée de l'état de charge. Au contraire, une valeur réelle particulière de l'état de charge est obtenue par détection d'un phénomène physique caractéristique permettant d'affirmer que la valeur instantanée de l'état de charge est égale à une valeur connue, prédéterminée, au moment de la détection dudit phénomène physique caractéristique.

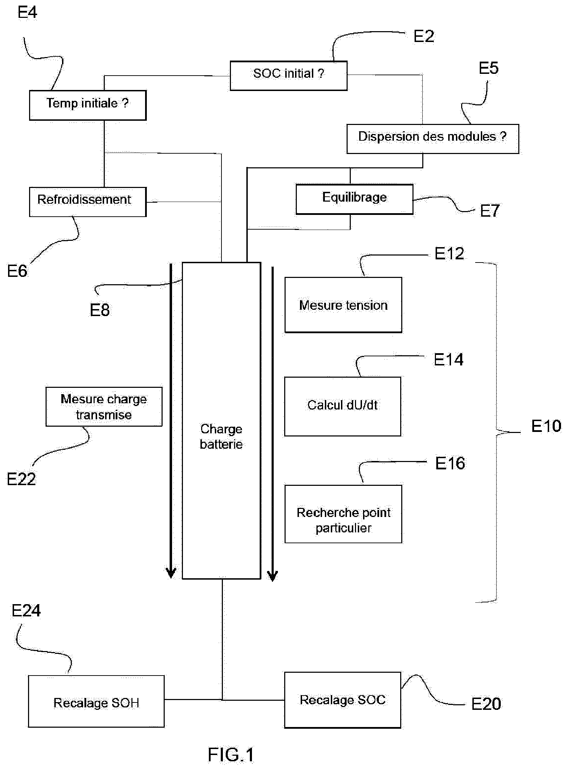

La figure 1 illustre les étapes d'une phase de recalage d'un procédé d'estimation de l'état de charge d'une batterie selon un mode de réalisation de l'invention, appliquée à titre d'exemple à un pack batterie construit avec la technologie Lithium Manganèse Titanate.

Dans une première étape E2, le procédé vérifie si l'état de charge SOC de la batterie, tel qu'estimé par la jauge d'état de charge, même imparfaite avant son recalage, ou par tout autre moyen, comme à partir d'une mesure de tension à vide du système électrochimique de la batterie qui peut aussi être représentative de l'état de charge de la batterie, se trouve dans une fourchette acceptable pour la mise en oeuvre d'une phase de recalage. Il faut en effet se trouver dans une position qui va permettre d'atteindre un des points remarquables de la courbe de dérivée de la tension. Dans l'exemple considéré, cette fourchette est avantageusement définie par SOC < 40%, ce qui permet de garantir de pouvoir détecter le maximum $P_{max}$ de la courbe de dérivée de la tension lors d'une prochaine charge de la batterie. En variante, cette fourchette peut être entre 56 et 60 % dans l'optique de détecter le point minimum $P_{min}$ de la courbe. Si la condition prédéfinie n'est pas vérifiée lors de cette étape E2, la phase de recalage n'est pas engagée.

Dans une étape E4, le procédé mesure la température de la batterie, et la compare à une température de référence, qui est en général la température ambiante, par exemple proche de 20° C et de préférence entre 15 et 30 °C. Si cette température est supérieure à la température de référence, une étape E6 de refroidissement de la batterie est de préférence mise en oeuvre, jusqu'à atteindre sensiblement la température de référence recherchée, ou une valeur ne s'éloignant pas de plus de 20% de cette température de référence. En variante, un réchauffement de la batterie peut aussi être implémenté si celle-ci se trouve à trop basse température.

D'autre part, dans une étape E5, le procédé met en oeuvre une étape de mesure de la dispersion des états de charge de sous-ensembles de la batterie. Pour cela, le procédé met en oeuvre une comparaison des états de charge de chaque sous-ensemble, obtenus par une jauge ciblant spécifiquement chaque sous-ensemble. Cette comparaison peut reposer sur un calcul statistique permettant de mesurer la dispersion des valeurs obtenues. En cas de dispersion dépassant un certain seuil, une étape d'équilibrage E7 est mise en oeuvre, permettant d'atteindre un état de charge sensiblement identique de tous les sous-ensembles de la batterie. Cet équilibrage peut comprendre la décharge des sous-ensembles les plus chargés. A titre indicatif, et non limitatif, le seuil acceptable de dispersion peut être fixé égal à 1 ou à quelques pourcents de la valeur moyenne des niveaux d'états de charge des sous-ensembles.

Les étapes précédentes E4 à E7 permettent de positionner la batterie dans un état initial favorable, pour atteindre la performance maximale du procédé qui va être décrit par la suite. L'ajustement de la température E4, E6 et l'ajustement de l'état de charge des sous-ensembles de la batterie E5, E7 peuvent être mis en oeuvre dans un ordre quelconque. Toutefois, ces ajustements restent optionnels. En variante, un seul des deux ajus-

Ensuite, le procédé se poursuit par la mise en route d'une étape de charge E8 de la batterie, dans des conditions de courant de charge prédéfini, de préférence à courant constant. D'autre part, les conditions de charge sont aussi de préférence choisies pour maintenir cette température de la batterie sensiblement constante, en évitant par exemple les forts régimes. Les conditions nominales de charge, données par le constructeur, représentent à titre d'exemple une bonne solution.

Pendant cette étape de charge E8 de la batterie, la phase de recalage met en oeuvre une étape E10 simultanée d'observation de la courbe formée par l'évolution de la dérivée temporelle de la tension, selon la même approche que celle explicitée précédemment, à partir d'une mesure périodique de la tension aux bornes de la batterie.

Ainsi, selon ce mode de réalisation, cette étape E10 comprend les sous-étapes suivantes :

- Mesure de la tension E12 aux bornes de la batterie selon une fréquence prédéfinie ;
- Estimation de la dérivée temporelle E14 de cette tension, par exemple à partir d'une moyenne sur une fourchette glissante ;
- Recherche d'un point particulier E16 de la courbe obtenue par cette dérivée temporelle.

L'estimation de la dérivée temporelle E14 de la tension peut être effectuée selon la méthode explicitée précédemment.

Cette étape de recherche d'un point particulier E16 peut être mise en oeuvre par toute méthode mathématique ou de calcul connue. Avantageusement, ce point particulier est un maximum ou un minimum, sur une certaine portion de la courbe observée, dont la détection se fait par la détection d'un changement de pente de la courbe de part et d'autre de ce point. Lorsque ce point particulier est déterminé, le procédé en déduit la valeur correspondante de l'état de charge de la batterie, puis engage une étape finale de recalage E20 du calcul d'estimation : ce recalage se fait alors de manière similaire à l'état de la technique, l'invention ne porte pas spécifiquement sur cette dernière étape.

On note que les étapes E8 et E10 explicitées ci-dessus correspondent en fait à un procédé de détection d'une valeur prédéfinie d'un état de charge d'une batterie, sur lequel porte aussi l'invention.

En remarque, le procédé d'estimation d'état de charge selon le mode de réalisation comprend une étape préalable de calibration E0, qui permet de déterminer les points particuliers de la courbe de la dérivée temporelle de la tension de la batterie durant sa charge, à la température de référence et dans des conditions de charge choisies, avantageusement les conditions nominales. Cette étape de calibration E0 permet naturellement d'associer les valeurs d'état de charge de la batterie à ces points particuliers. Cette étape peut être réalisée pour chaque batterie neuve, avant sa mise en service, par exemple par le constructeur lui-même, ou pour toute une famille de batteries, voire ultérieurement sur une batterie non obligatoirement neuve, par exemple par un utilisateur.

Le procédé décrit ci-dessus atteint les objets recherchés et présente l'avantage de ne pas nécessiter de charge ou décharge totale de la batterie, ni de phase de repos, pour la phase de recalage de son procédé d'estimation de son état de charge, mais peut fonctionner sur une courte durée de charge de la batterie, puisqu'il est possible d'engager la phase de recalage dans un état initial de la batterie proche du point particulier à détecter, qui met fin à la phase de recalage. Ainsi, la phase de recalage devient beaucoup moins contraignante.

L'invention porte aussi sur une batterie associée à un système de gestion, qui comprend des moyens matériels (hardware) et/ou logiciels (software), au moins un calculateur, pour mettre en oeuvre le procédé de gestion de la batterie, plus précisément d'estimation de l'état de charge et la mise en oeuvre des phases de recalage, détaillé ci-dessus. Ce système de gestion pilote notamment les étapes de calcul, de mesure et/ou d'estimations de grandeurs physiques, comme la température, le courant, la tension, ... Ce système de gestion de la batterie est intégré ou non au sein de la structure de la batterie. Avantageusement, la batterie comprend au moins un capteur de température pour mesurer sa température et au moins un capteur de mesure de tension, ces capteurs étant liés par un moyen de communication avec le calculateur. Le système de gestion comprend de plus une mémoire pour mémoriser tout ou partie des valeurs mesurées et/ou calculées dans les différentes étapes du procédé.

Le mode de réalisation précédent a été décrit pour estimer au mieux l'état de charge d'une batterie. Dans le cas d'une batterie comprenant une architecture de pack batterie, il est possible de mettre en oeuvre l'estimation de l'état de charge pour l'ensemble du pack batterie et/ou pour des batteries élémentaires ou des sous-ensembles quelconques du pack batterie, pour détecter les dispersions entre ces sous-ensembles.

Dans le cas où la phase de recalage est mise en oeuvre à partir d'un état totalement déchargé de la batterie, il est possible de mettre en oeuvre de manière très similaire une phase de recalage d'un procédé d'estimation de l'état de santé SOH de la batterie. L'état de santé d'une batterie se définit à partir de la capacité de référence de la batterie, appelée Cref. Cette capacité de référence représente la quantité de charge maximale que la batterie, initialement chargée, peut restituer au cours d'une décharge. Elle se définit ainsi en considérant une charge et une décharge effectuées dans des conditions nominales (régimes ou profil de courant, température, critères de fin de charge et de décharge). Cette capacité de référence diminue avec le temps, puisqu'avec son vieillissement, la batterie devient moins performante. Ainsi, si on appelle Cref(t0) la capacité de référence de la batterie à l'instant initial puis Cref(t) sa capacité de référence à un instant t, l'état de santé SOH(t) de la batterie à l'instant t se définit de la manière suivante :

$$SOH(t) = Cref(t) \,/\, Cref(t0).$$

La phase de recalage de l'état de santé de la batterie comprend une étape de mesure de la charge Ah(tr) transmise E22 à la batterie entre son état déchargé et son état intermédiaire correspondant à un point particulier pour lequel son état de charge est connu, à l'instant tr de recalage.

Cette même mesure est réalisée à l'état neuf de la batterie, par exemple lors de l'étape de calibration, qui permet ainsi de mesurer et de mémoriser la charge Ah(t0) transmise à la batterie jusqu'au même point particulier à l'état neuf de la batterie.

A partir de ces calculs, le procédé en déduit une valeur réelle de l'état de santé de la batterie à l'instant tr, par la formule suivante :

$$SOH(tr) = Ah(tr) \,/\, Ah(t0)$$

Cette valeur réelle est ensuite utilisée pour une étape de recalage E24 de l'algorithme de calcul de l'état de santé.

Cette phase de recalage de l'algorithme d'estimation de l'état de santé peut être combinée à celle du procédé d'estimation de l'état de charge, voire être distincte et indépendante.

Les phases de recalage décrites précédemment sont faites à l'aide d'une charge partielle d'une batterie. En variante, des étapes similaires peuvent être mises en oeuvre avec des décharges partielles d'une batterie.

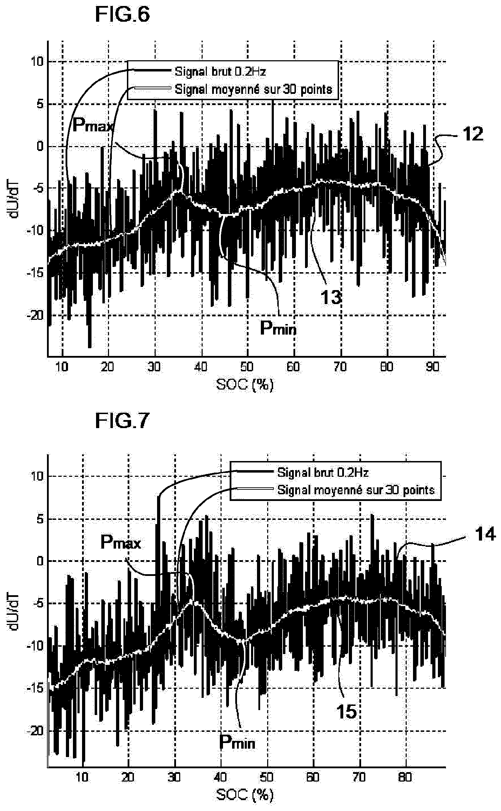

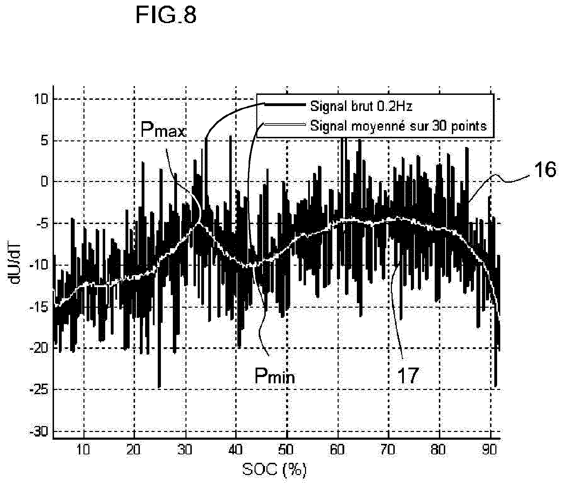

En effet, les figures 6 à 8 représentent à titre d'exemple respectivement des courbes 13, 15, et 17 montrant l'évolution de la dérivée temporelle de la tension aux bornes d'un pack batterie de technologie Lithium Manganèse Titanate en fonction de l'état de charge de ce pack batterie pour respectivement différents états de vieillissements de la batterie, plus précisément pour respectivement 3400, 8000, et 16900 cycles de charges/décharges de la batterie. Ces courbes sont établies lors d'une phase de décharge de la batterie, au contraire des courbes 3, 5, 7 et 9 étudiées précédemment.

L'obtention de ces courbes 13, 15, et 17 peut être faite de manière similaire aux courbes 3, 5, 7 et 9 décrites précédemment mais à partir de l'état totalement chargé de la batterie et au cours de sa décharge. .Avantageusement, ces courbes représentent la dérivée temporelle filtrée, pour obtenir des courbes lissées, par rapport aux courbes 12, 14, et 16 issues des mesures instantanées.

Les courbes 13, 15, et 17 montrent que la dérivée temporelle de la tension présente une forme similaire quel que soit l'état de vieillissement de la batterie, et présentent notamment deux points particuliers qui sont d'une part un maximum $P_{max}$ et d'autre part un minimum $P_{min}$, obtenus respectivement pour des valeurs de l'état de charge de respectivement 30% et 50%, de manière sensiblement indépendante du vieillissement de la batterie, à une température entre 15 et 30 °C de la batterie. Plus généralement, le point maximum $P_{max}$ de la courbe de la dérivée temporelle de la tension aux bornes de la batterie est obtenu pour une valeur d'état de charge comprise entre 30 et 36%, voire entre 32 et 35%. De plus, on note que la dérivée temporelle de la tension prend une valeur proche de -5 $V.s^{-1}$ à ce point maximum $P_{max}$, plus généralement entre -5,5 et -4,5 $V.s^{-1}$. De plus, le point minimum $P_{min}$ de la courbe de la dérivée temporelle de la tension aux bornes de la batterie est obtenu pour une valeur d'état de charge comprise entre 40 et 46%, et la dérivée temporelle de la tension prend une valeur entre -10 et -8 $V.s^{-1}$ à ce point minimum $P_{min}$.

Ainsi, il apparaît que le procédé d'évaluation de l'état de charge d'une batterie décrit précédemment peut être mis en oeuvre de manière très similaire en remplaçant l'étape de charge E8 par une étape de décharge E8. En remarque toutefois, il faut prendre en compte le fait que les points particuliers $P_{max}$ et $P_{min}$ sont différents dans cette approche et il faut donc appliquer le même procédé en recherchant ces points particuliers différents.

Ainsi, dans la première étape E2 où le procédé vérifie si l'état de charge SOC de la batterie, se trouve dans une fourchette acceptable pour la mise en oeuvre d'une phase de recalage, cette fourchette est avantageusement définie par SOC < 50 %.

Par ailleurs, et de façon générale, il est possible de recaler le SOH lors d'une charge ou d'une décharge par évaluation d'une charge en Ah entre deux niveaux de SOC connus. Ainsi, dans une phase de charge, il est possible de recaler le SOH en estimant la charge en Ah entre un état de charge SOC égale à 0% et un niveau égal au SOC d'un point particulier « en charge » (par exemple 60%) ou en estimant la charge en Ah entre ce point particulier et un état de charge SOC égal à 100%. De même, lors d'une décharge, il est possible de recaler le SOH en estimant la charge en Ah entre un état de charge SOC de 100% et un niveau égal au SOC d'un point particulier « en décharge » ou en estimant la charge en Ah entre ce point particulier et un état de charge SOC égal à 0%. Comme expliqué précédemment, le SOH actuel est obtenu par ratio entre la charge Ah(tr) entre deux niveaux de SOC connus et la charge en Ah(t0) entre ces mêmes niveaux de SOC à l'état neuf de la batterie.

**Revendications**

1. Procédé d'évaluation de l'état de charge d'une batterie comprenant au moins une phase d'estimation de l'état de charge de la batterie par un algorithme d'estimation de l'état de charge et au moins une phase de recalage de l'algorithme d'estimation mis en oeuvre durant la phase d'estimation, **caractérisé en ce que** la phase de recalage comprend la mise en oeuvre des étapes suivantes :

- détection d'une valeur réelle d'un état de charge de la batterie à un instant donné par la mise en oeuvre des étapes suivantes :

- charger ou décharger (E8) la batterie, entre des premier et second niveaux d'état de charge ;
- mesurer (E12) la tension aux bornes de la batterie durant cette charge ou décharge ;
- évaluer la dérivée temporelle (E14) de ladite tension ;
- détecter au moins un point particulier (E16) de cette dérivée correspondant à une valeur réelle d'état de charge connue et prédéfinie,

- recalage (E20) de l'algorithme d'estimation connaissant ladite valeur réelle d'état de charge audit instant donné.

2. Procédé d'évaluation de l'état de charge d'une batterie selon la revendication précédente, **caractérisé en ce que** la recherche d'un point particulier (E16) de la courbe de dérivée temporelle de la tension aux bornes de la batterie consiste en la détection d'une valeur maximale ou minimale sur une portion de cette courbe.

3. Procédé selon l'une des revendications précédentes, dans lequel, lors de la mise en oeuvre du procédé de détection d'une valeur prédéfinie d'un état de charge, l'étape d'évaluation de la dérivée temporelle (E14) de la tension comprend une étape d'estimation instantanée de la dérivée temporelle de la tension puis une étape de lissage des estimations de la dérivée.

4. Procédé d'évaluation de l'état de charge d'une batterie selon la revendication 3, **caractérisé en ce que** l'étape de lissage comprend une étape de calcul d'une moyenne sur une fourchette glissante des estimations de la dérivée.

5. Procédé d'évaluation de l'état de charge d'une batterie selon l'une des revendications précédentes, **caractérisé en ce qu'**il comprend une étape de détection (E2) pour détecter si l'état de charge de la batterie se trouve dans une plage permettant le lancement ou non d'une phase de recalage.

6. Procédé d'évaluation de l'état de charge d'une batterie selon l'une des revendications précédentes, **caractérisé en ce qu'**il comprend la mise en oeuvre d'une phase de recalage d'un algorithme d'estimation de l'état de santé de la batterie si la batterie est complètement déchargée.

7. Procédé d'évaluation de l'état de charge d'une batterie selon la revendication précédente, **caractérisé en ce que** la phase de recalage de l'algorithme d'estimation de l'état de santé de la batterie comprend les étapes suivantes :

- charge (E8) de la batterie,
- estimation de la charge transmise à la batterie depuis le début de la charge (E8),
- observation de la dérivée temporelle (E10) de la tension aux bornes de la batterie pour déterminer au moins un point particulier de cette dérivée,
- recalage (E24) de l'algorithme d'estimation de l'état de santé à partir de la charge totale transmise à la batterie jusqu'à l'atteinte dudit point particulier.

8. Procédé d'évaluation de l'état de charge d'une batterie selon l'une des revendications précédentes, **caractérisé en ce qu'**il comprend une étape de mesure de température (E4) de la batterie, et une étape de refroidissement ou réchauffement (E6) de la batterie si la température de la batterie ne se trouve pas dans une plage de plus ou moins 20% autour d'une valeur de température de référence.

9. Procédé d'évaluation de l'état de charge d'une batterie selon l'une des revendications précédentes, **caractérisé en ce qu'**il comprend une étape d'estimation de la dispersion (E5) des états de charge de plusieurs sous-ensembles de la batterie, et une étape d'équilibrage (E7) de ces états de charge si la dispersion se trouve au-delà d'un seuil, l'étape d'équilibrage étant réalisée préalablement à la mise en oeuvre du procédé de détection d'une valeur prédéfinie selon la revendication 1.

10. Procédé d'évaluation de l'état de charge d'une batterie selon l'une des revendications précédentes, **caractérisé en ce qu'**il comprend l'évaluation de l'état de charge d'une batterie comprenant une ou plusieurs batterie(s) élémentaire(s) de type Lithium Manganèse Titanate, dont le lancement de la phase de recalage par charge de la batterie est accepté si l'état de charge est inférieur à 40% ou si l'état de charge est entre 56 et 60 %, et **en ce que** l'étape de recalage (E20) de la phase de recalage associe une valeur d'état de charge comprise entre 50 et 60%, voire entre 53 et 56%, pour un point maximum $P_{max}$ de la courbe de la dérivée temporelle (E10) de la tension aux bornes de la batterie, dont la valeur de la dérivée temporelle est comprise entre 10 et 13 $V.s^{-1}$, voire entre 11 et 12 $V.s^{-1}$, et/ou une valeur d'état de charge comprise entre 60 et 65% pour un point minimum $P_{min}$ de cette courbe, dont la valeur de la dérivée temporelle est comprise entre 4 et 5 $V.s^{-1}$, à une température entre 15 et 30 °C de la batterie.

11. Procédé d'évaluation de l'état de charge d'une batterie selon l'une des revendications 1 à 9, **caractérisé en ce qu'**il comprend l'évaluation de l'état de charge d'une batterie comprenant une ou plusieurs batterie(s) élémentaire(s) de type Lithium Manganèse Titanate, dont le lancement de la phase de recalage par décharge de la batterie est accepté si son état de charge est supérieur à 40% ou 50%, et **en ce que** l'étape de recalage (E20) de la phase de recalage associe une valeur d'état de charge comprise entre 32 et 35%, voire entre 30 et 36%, pour un point maximum $P_{max}$ de la courbe de la dérivée temporelle (E10) de la tension aux bornes de la batterie, dont la valeur de la dérivée temporelle est comprise entre -5,5 et -4,5 $V.s^{-1}$, et/ou une valeur d'état de charge comprise entre 40 et 46% pour un point minimum $P_{min}$ de cette courbe, dont la valeur de la dérivée temporelle est comprise entre -10 et -8 $V.s^{-1}$, à une température entre 15 et 30 °C de la batterie.

12. Procédé d'évaluation de l'état de charge d'une batterie selon l'une des revendications précédentes, **caractérisé en ce qu'**il comprend une étape préalable de calibration (E0), consistant en une étape de tracé d'au moins une partie de la courbe de la dérivée temporelle (E14) de la tension aux bornes de la batterie en phase de charge ou décharge, la détection d'au moins un point particulier de cette courbe, et la mesure de l'état de charge associé audit au moins un point particulier.

13. Procédé d'évaluation de l'état de charge d'une batterie selon l'une des revendications précédentes, **caractérisé en ce qu'**il met en oeuvre une évaluation de l'état de charge pour plusieurs batteries élémentaires d'un même pack batterie.

14. Système comprenant une batterie et un calculateur associé à la batterie, le calculateur pilotant le procédé d'évaluation de son état de charge selon l'une des revendications précédentes.

15. Système selon la revendication précédente, **caractérisé en ce qu'**il comprend au moins un capteur de température de la batterie et au moins un capteur de tension et/ou de courant aux bornes de la batterie, et un dispositif de communication de ces capteurs vers le calculateur pour lui transmettre leurs mesures.

16. Système selon la revendication 14 ou 15, **caractérisée en ce que** la batterie est de type Lithium Manganèse Titanate.

17. Système de gestion d'une batterie, **caractérisé en ce qu'**il comprend au moins un calculateur qui met en oeuvre et pilote le procédé d'évaluation de l'état de charge de la batterie selon l'une des revendications 1 à 13.

18. Support informatique lisible par une unité de gestion, **caractérisé en ce qu'**il comprend un programme informatique enregistré comprenant des moyens de codes de programme informatique de mise en oeuvre et pilotage du procédé d'évaluation de l'état de charge de la batterie selon l'une des revendications 1 à 13.

**Patentansprüche**

1. Verfahren zur Berechnung des Ladezustands einer Batterie, umfassend mindestens eine Phase des Abschätzens des Ladezustands der Batterie durch einen Algorithmus zum Abschätzen des Ladezustands und mindestens eine Einstellungsphase des Algorithmus zum Abschätzen, die während der Phase des Abschätzens umgesetzt wird, **dadurch gekennzeichnet, dass** die Einstellungsphase das Durchführen der folgenden Schritte aufweist:

    - Erfassen eines Istwertes eines Ladezustands der Batterie zu einem bestimmten Zeitpunkt durch das Durchführen der folgenden Schritte:

        - Laden oder Entladen (E8) der Batterie zwischen dem ersten und zweiten Ladezustandsniveau,
        - Messen (E12) der Spannung an den Klemmen der Batterie während dieses Ladens oder Entladens,
        - Berechnen der zeitlichen Ableitung (E14) der Spannung,
        - Erfassen von mindestens einem besonderen Punkt (E16) dieser Ableitung, der einem bekannten und vorbestimmten Istwert des Ladezustands entspricht,

    - Einstellen (E20) des Algorithmus zum Abschätzen, der den Istwert des Ladezustands zu dem bestimmten Zeitpunkt kennt.

2. Verfahren zur Berechnung des Ladezustands einer Batterie nach dem vorhergehenden Anspruch, **dadurch gekennzeichnet, dass** das Suchen eines bestimmten Punktes (E16) der Kurve der zeitlichen Ableitung der Spannung an den Klemmen der Batterie aus dem Erfassen eines Maximal- oder Minimalwertes auf einem Abschnitt dieser Kurve besteht.

3. Verfahren nach einem der vorhergehenden Ansprüche, wobei beim Umsetzen des Verfahrens des Erfassens von einem vorbestimmten Wert eines Ladezustands der Schritt des Berechnens der zeitlichen Ableitung (E14) der Spannung einen Schritt des sofortigen Abschätzens der zeitlichen Ableitung der Spannung und dann einen Schritt des Glättens der Abschätzungen der Ableitung aufweist.

4. Verfahren zur Berechnung des Ladezustands einer Batterie nach Anspruch 3, **dadurch gekennzeichnet, dass** der Schritt des Glättens einen Schritt des Berechnens eines Mittelwerts auf einer gleitenden Spanne der Abschätzungen der Ableitung aufweist.

5. Verfahren zur Berechnung des Ladezustands einer Batterie nach einem der vorhergehenden Ansprüche, **dadurch gekennzeichnet, dass** es einen Schritt des Erfassens (E2) aufweist, um zu erfassen, ob sich der Ladezustand der Batterie in einem Bereich befindet, der das Starten oder nicht einer Einstellungsphase ermöglicht.

6. Verfahren zur Berechnung des Ladezustands einer Batterie nach einem der vorhergehenden Ansprüche, **dadurch gekennzeichnet, dass** es das Umsetzen einer Einstellungsphase eines Algorithmus zum Abschätzen des Gesundheitszustands der Batterie aufweist, wenn die Batterie vollständig entladen ist.

7. Verfahren zur Berechnung des Ladezustands einer Batterie nach dem vorhergehenden Anspruch, **dadurch gekennzeichnet, dass** die Einstellungsphase des Algorithmus zum Abschätzen des Gesundheitszustands der Batterie die folgenden Schritte aufweist:

   - Laden (E8) der Batterie,
   - Abschätzen der Ladung, die seit dem Beginn der Ladung auf die Batterie übertragen wird (E8),
   - Beobachten der zeitlichen Ableitung (E10) der Spannung an den Klemmen der Batterie, um mindestens einen bestimmen Punkt dieser Ableitung zu bestimmen,
   - Einstellen (E24) des Algorithmus zum Abschätzen des Gesundheitszustands ausgehend von der Gesamtladung, die bis zu dem Erreichen des bestimmten Punktes auf die Batterie übertragen wird.

8. Verfahren zur Berechnung des Ladezustands einer Batterie nach einem der vorhergehenden Ansprüche, **dadurch gekennzeichnet, dass** es einen Schritt des Temperaturmessens (E4) der Batterie und einen Schritt des Kühlens oder Erwärmens (E6) der Batterie aufweist, wenn sich die Temperatur der Batterie nicht in einem Bereich von plus oder minus 20 % um einen Referenztemperaturwert befindet.

9. Verfahren zur Berechnung des Ladezustands einer Batterie nach einem der vorhergehenden Ansprüche, **dadurch gekennzeichnet, dass** es einen Schritt des Abschätzens der Dispersion (E5) der Ladezustände von mehreren Untereinheiten der Batterie und einen Schritt des Ausgleichens (E7) dieser Ladezustände aufweist, wenn sich die Dispersion über einem Schwellenwert befindet, wobei der Schritt des Ausgleichens vor dem Umsetzen des Verfahrens zum Erfassen eines vorbestimmten Wertes nach Anspruch 1 durchgeführt wird.

10. Verfahren zur Berechnung des Ladezustands einer Batterie nach einem der vorhergehenden Ansprüche, **dadurch gekennzeichnet, dass** es das Berechnen des Ladezustands einer Batterie aufweist, die eine oder mehrere Elementarbatterien vom Typ der Lithium-Mangan-Titanat-Batterie aufweist, wobei das Starten der Einstellungsphase durch Laden der Batterie akzeptiert wird, wenn der Ladezustand unter 40 % liegt oder wenn der Ladezustand zwischen 56 und 60 % beträgt, und dass der Schritt des Einstellens (E20) der Einstellungsphase einen Wert des Ladezustands zwischen 50 und 60 % oder sogar zwischen 53 und 56 % für einen maximalen Punkt $P_{max}$ der Kurve der zeitlichen Ableitung (E10) der Spannung an den Klemmen der Batterie, dessen Wert der zeitlichen Ableitung zwischen 10 und 13 $V.s^{-1}$ oder sogar zwischen 11 und 12 $V.s^{-1}$ beträgt, und/oder einen Wert des Ladezustands zwischen 60 und 65 % für einen minimalen Punkt $P_{min}$ dieser Kurve zuordnet, dessen Wert der zeitlichen Ableitung zwischen 4 und 5 $V.s^{-1}$ bei einer Temperatur zwischen 15 und 30 °C der Batterie beträgt.

11. Verfahren zur Berechnung des Ladezustands einer Batterie nach einem der Ansprüche 1 bis 9, **dadurch gekennzeichnet, dass** es das Berechnen des Ladezustands einer Batterie aufweist, die eine oder mehrere Elementarbatterien vom Typ der Lithium-Mangan-Titanat-Batterie aufweist, wobei das Starten der Einstellungsphase durch Entladen der Batterie akzeptiert wird, wenn ihr Ladezustand über 40 % oder 50 % beträgt, und dass der Schritt des Einstellens (E20) der Einstellungsphase einen Wert des Ladezustands zwischen 32 und 35 % oder sogar zwischen 30 und 36 % für einen maximalen Punkt $P_{max}$ der Kurve der zeitlichen Ableitung (E10) der Spannung an den Klemmen der Batterie, dessen Wert der zeitlichen Ableitung zwischen -5,5 und -4,5 $V.s^{-1}$ beträgt, und/oder einen Wert des Ladezustands zwischen 40 und 46 % für einen minimalen Punkt $P_{min}$ dieser Kurve zuordnet, dessen Wert der zeitlichen Ableitung zwischen -10 und -8 $V.s^{-1}$ bei einer Temperatur zwischen 15 und 30 °C der Batterie beträgt.

**12.** Verfahren zur Berechnung des Ladezustands einer Batterie nach einem der vorhergehenden Ansprüche, **dadurch gekennzeichnet, dass** es einen vorhergehenden Schritt des Kalibrierens (E0) aufweist, der aus einem Schritt des Erstellens von mindestens einem Teil der Kurve der zeitlichen Ableitung (E14) der Spannung an den Klemmen der Batterie in der Phase des Ladens oder Entladens, dem Erfassen von mindestens einem bestimmten Punkt dieser Kurve und dem Messen des Ladezustands, der diesem mindestens einen bestimmten Punkt zugeordnet ist, besteht.

**13.** Verfahren zur Berechnung des Ladezustands einer Batterie nach einem der vorhergehenden Ansprüche, **dadurch gekennzeichnet, dass** es eine Berechnung des Ladezustands für mehrere Elementarbatterien eines gleichen Batteriepacks durchführt.

**14.** System, umfassend eine Batterie und einen Rechner, der mit der Batterie verbunden ist, wobei der Rechner das Verfahren zur Berechnung ihres Ladezustands nach einem der vorhergehenden Ansprüche steuert.

**15.** System nach dem vorhergehenden Anspruch, **dadurch gekennzeichnet, dass** es mindestens einen Temperatursensor der Batterie und mindestens einen Spannungs- und/oder Stromsensor an den Klemmen der Batterie und eine Kommunikationsvorrichtung dieser Sensoren zu dem Rechner aufweist, um ihm ihre Messungen zu übermitteln.

**16.** System nach Anspruch 14 oder 15, **dadurch gekennzeichnet, dass** die Batterie vom Typ der Lithium-Mangan-Titanat-Batterie ist.

**17.** System zur Verwaltung einer Batterie, **dadurch gekennzeichnet, dass** es mindestens einen Rechner aufweist, der das Verfahren zur Berechnung des Ladezustands der Batterie nach einem der Ansprüche 1 bis 13 umsetzt und steuert.

**18.** Datenträger, der von einer Steuereinheit lesbar ist, **dadurch gekennzeichnet, dass** er ein aufgezeichnetes Computerprogramm aufweist, das Computerprogrammcodemittel zum Umsetzen und Steuern des Verfahrens zur Berechnung des Ladezustands der Batterie nach einem der Ansprüche 1 bis 13 aufweist.

**Claims**

**1.** Method for evaluating the state of charge of a battery comprising at least one phase of estimating the state of charge of the battery by an algorithm for estimating the state of charge and at least one phase of resetting of the estimation algorithm implemented during the estimation phase, **characterized in that** the resetting phase comprises the implementation of the following steps:

- detection of a real value of a state of charge of the battery at an instant given by the implementation of the following steps:

- charging or discharging (E8) the battery, between first and second levels of state of charge;
- measuring (E12) the voltage across the terminals of the battery during this charging or discharging;
- evaluating the time derivative (E14) of the said voltage;
- detecting at least one particular point (E16) of this derivative corresponding to a known and predefined real value of state of charge,

- resetting (E20) of the estimation algorithm knowing the said real value of state of charge at the said given instant.

**2.** Method for evaluating the state of charge of a battery according to the preceding claim, **characterized in that** the search for a particular point (E16) of the curve of time derivative of the voltage across the terminals of the battery consists in the detection of a maximum or minimum value over a portion of this curve.

**3.** Method according to one of the preceding claims, in which, during the implementation of the method for detecting a predefined value of a state of charge, the step of evaluating the time derivative (E14) of the voltage comprises a step of instantaneously estimating the time derivative of the voltage and then a step of smoothing the estimations of the derivative.

**4.** Method for evaluating the state of charge of a battery according to Claim 3, **characterized in that** the smoothing step comprises a step of calculating an average over a sliding bracket of the estimations of the derivative.

**5.** Method for evaluating the state of charge of a battery according to one of the preceding claims, **characterized in that** it comprises a detection step (E2) to detect whether or not the state of charge of the battery lies in a range allowing the launching of a resetting phase.

**6.** Method for evaluating the state of charge of a battery according to one of the preceding claims, **characterized in that** it comprises the implementation of a phase of resetting of an algorithm for estimating the state of health of the battery if the battery is completely discharged.

7. Method for evaluating the state of charge of a battery according to the preceding claim, **characterized in that** the phase of resetting of the algorithm for estimating the state of health of the battery comprises the following steps:

- charging (E8) of the battery,
- estimation of the charge transmitted to the battery from the start of the charging (E8),
- observation of the time derivative (E10) of the voltage across the terminals of the battery to determine at least one particular point of this derivative,
- resetting (E24) of the algorithm for estimating the state of health on the basis of the total charge transmitted to the battery until the said particular point is attained.

8. Method for evaluating the state of charge of a battery according to one of the preceding claims, **characterized in that** it comprises a step of measurement of temperature (E4) of the battery, and a step of cooling or warming (E6) of the battery if the temperature of the battery does not lie in a range of plus or minus 20% around a reference temperature value.

9. Method for evaluating the state of charge of a battery according to one of the preceding claims, **characterized in that** it comprises a step of estimating the dispersion (E5) of the states of charge of several sub-assemblies of the battery, and a step (E7) of balancing these states of charge if the dispersion lies beyond a threshold, the balancing step being carried out prior to the implementation of the method for detecting a predefined value according to Claim 1.

10. Method for evaluating the state of charge of a battery according to one of the preceding claims, **characterized in that** it comprises the evaluation of the state of charge of a battery comprising one or more elementary battery (batteries) of Lithium Manganese Titanate type, the launching of whose resetting phase by charging of the battery is accepted if the state of charge is less than 40% or if the state of charge is between 56 and 60 %, and **in that** the resetting step (E20) of the resetting phase associates a state of charge value lying between 50 and 60%, or indeed between 53 and 56%, for a maximum point $P_{max}$ of the curve of the time derivative (E10) of the voltage across the terminals of the battery, the value of whose time derivative lies between 10 and 13 V.s$^{-1}$, or indeed between 11 and 12 V.s$^{-1}$, and/or a state of charge value lying between 60 and 65% for a minimum point $P_{min}$ of this curve, the value of whose time derivative lies between 4 and 5 V.s$^{-1}$, at a temperature between 15 and 30 °C of the battery.

11. Method for evaluating the state of charge of a battery according to one of Claims 1 to 9, **characterized in that** it comprises the evaluation of the state of charge of a battery comprising one or more elementary battery (batteries) of Lithium Manganese Titanate type, the launching of whose resetting phase by discharging of the battery is accepted if its state of charge is greater than 40% or 50%, and **in that** the resetting step (E20) of the resetting phase associates a state of charge value lying between 32 and 35%, or indeed between 30 and 36%, for a maximum point $P_{max}$ of the curve of the time derivative (E10) of the voltage across the terminals of the battery, the value of whose time derivative lies between -5.5 and -4.5 V.s$^{-1}$, and/or a state of charge value lying between 40 and 46% for a minimum point $P_{min}$ of this curve, the value of whose time derivative lies between -10 and -8 V.s$^{-1}$, at a temperature between 15 and 30 °C of the battery.

12. Method for evaluating the state of charge of a battery according to one of the preceding claims, **characterized in that** it comprises a prior calibration step (E0), consisting of a step of plotting at least one part of the curve of the time derivative (E14) of the voltage across the terminals of the battery in the charging or discharging phase, the detection of at least one particular point of this curve, and the measurement of the state of charge associated with the said at least one particular point.

13. Method for evaluating the state of charge of a battery according to one of the preceding claims, **characterized in that** it implements an evaluation of the state of charge for several elementary batteries of one and the same battery pack.

14. System comprising a battery and a processor associated with the battery, the processor driving the method for evaluating its state of charge according to one of the preceding claims.

15. System according to the preceding claim, **characterized in that** it comprises at least one sensor of temperature of the battery and at least one sensor of voltage and/or current across the terminals of the battery, and a device for communication of these sensors to the processor to transmit their measurements to it.

16. System according to Claim 14 or 15, **characterized in that** the battery is of Lithium Manganese Titanate type.

17. System for managing a battery, **characterized in that** it comprises at least one processor which implements and drives the method for evaluating the state of charge of the battery according to one of Claims 1 to 13.

18. Computer medium readable by a management unit, **characterized in that** it comprises a recorded computer program comprising computer program code means for implementing and driving the method for evaluating the state of charge of the battery according to one of Claims 1 to 13.

FIG.1

FIG.2

FIG.3

FIG.4

FIG.5

FIG.6

FIG.7

## FIG.8

## RÉFÉRENCES CITÉES DANS LA DESCRIPTION

### Documents brevets cités dans la description

- US 5061898 A
- US 2005225301 A1